# EUROPÄISCHE PATENTSCHRIFT

(11) **EP 1 943 629 B1**
(45) Veröffentlichungstag und Bekanntmachung des Hinweises auf die Patenterteilung: **25.03.2009**
(21) Anmeldenummer: 06806189.4
(22) Anmeldetag: 11.10.2006
(51) Int. Cl.: G08B 17/00

(54) **VORRICHTUNG ZUR BRANDERKENNUNG IN SCHALTSCHRÄNKEN**
FIRE DETECTION DEVICE IN SWITCHGEAR CABINETS
DISPOSITIF DE DETECTION D'INCENDIE DANS DES ARMOIRES ELECTRIQUES

(30) Priorität: 04.11.2005 DE 102005052777
(43) Veröffentlichungstag der Anmeldung: 16.07.2008
(60) Teilanmeldung: 09150209.6
(73) Patentinhaber: Amrona AG, 6302 Zug (CH)
(72) Erfinder:
(74) Vertreter: Rupprecht, Kay
(86) Internationale Anmeldenummer: PCT/EP2006/009825
(87) Internationale Veröffentlichungsnummer: WO 2007/051517

(56) Entgegenhaltungen:
- EP-A2- 1 413 997
- WO-A-03/069571
- WO-A-20/05048207
- WO-A1-20/05030338

## Beschreibung

Die vorliegende Erfindung betrifft eine Vorrichtung zur Branderkennung in Schaltschränken, mit einem Ansaugrohrsystem, welches mit dem zu überwachenden Schaltschrank über zumindest eine Ansaugöffnung kommuniziert, und über welches aus dem zu überwachenden Schaltschrank eine repräsentative Luftprobe entnommen wird, und mit einem Brandfrüherkennungsmodul, welches zumindest eine Detektionseinheit zum Nachweisen von zumindest einer Brandkenngröße in der über das Ansaugrohrsystem angesaugten Luftprobe und eine Steuerung zur Abgabe eines Branderkennungssignals in Erwiderung auf ein mit der zumindest einen Detektionseinheit ausgegebenes Nachweisergebnis aufweist. Eine solche Vorrichtung wird im Dokument WO 03/069571A offenbart.

Unter dem Begriff "Schaltschrank" sind vorliegend sämtliche Schränke zu verstehen, die elektronische Bauteile oder Geräte beherbergen, so z.B. EDV-Anlagenschränke, Netzwerkschränke, Produktionssteuerungsschränke, elektronische Steuerungsschränke oder auch Telekommunikationsschränke. Des weiteren ist in der vorliegenden Beschreibung unter dem Begriff "Brandfrüherkennung" die Detektion eines Brandes bereits in seiner Entstehungsphase zu verstehen, wobei die Brandfrüherkennung selbstverständlich auch das Erkennen eines bereits entstandenen Brandes beinhaltet. Jedoch ist es das Ziel einer Brandfrüherkennung, einen Entstehungsbrand bereits in der so genannten Pyrolysephase zu detektieren, während der die erhitzen Stoffe, z.B. Kabelumwandlungen, bereits Rauchaerosole abgeben. Unter dem Begriff "Brandkenngröße" werden physikalische Größen verstanden, die in der Umgebung eines Entstehungsbrandes messbaren Veränderungen unterliegen, z.B. die Umgebungstemperatur, der Feststoff- oder Flüssigkeits- oder Gasanteil in der Umgebungsluft (Bildung von Rauch in Form von Partikeln oder Aerosolen oder Dampf) oder die Umgebungsstrahlung.

Dicnstleistungs- und Produktionsunternehmen sind in immer größerem Maße von der Funktionsfähigkeit und der hohen Verfügbarkeit ihrer EDV-Anlagen abhängig. Daher wird dem Brandschutz bei großen Rechenzentren oder Stromversorgungsanlagen meist eine entsprechend große Bedeutung eingeräumt. Doch oft sind es wenige oder sogar einzeln platzierte Netzwerk- oder Steuerungsschränke, die einen Großteil der betrieblichen Abläufe sichern. Damit kommen die zentralbetriebene Netzwerkschränke oder einzelne Steuerungsschränke in den unterschiedlichsten Abteilungen eines Unternehmens zum Einsatz. Häufig stehen diese Schränke ungeachtet ihrer großen Bedeutung in nicht durch eine Brandmeldeanlage überwachten Räumen. Diese technischen Anlagen werden deshalb ein oft unterschätztes Risiko, denn ein nicht rechtzeitig erkannter Brand kann schnell zu maßiven Betriebs- oder Produktionsstörungen führen. Um mögliche Brandschäden an dem elektronischen "Innenleben" eines solchen Schaltschranks auf ein Minimum zu reduzieren oder gar zu vermeiden, sind die Anforderungen an den Brandschutz sehr hoch und sollten eine frühest mögliche Detektion, Abschaltung der Energiezufuhr und schnelle sowie rückstandsfreie Löschung des Entstehungsbrandes enthalten.

Aus der DE 10 2004 048 233 ist beispielsweise eine Vorrichtung der eingangs genannten Art bekannt. Dieses aus dem Stand der Technik bekannte System weist eine Vorrichtung zur Brandfrüherkennung auf, welche sich im wesentlichen aus einer Lüftereinheit und einem Detektor zum Erkennen einer Brandkenngröße in einer mit Hilfe der Lüftereinheit angesaugten Luftprobe zusammensetzt. Im einzelnen ist dabei vorgesehen, die Vorrichtung zur Brandfrüherkennung oberhalb des Gehäuses des zu überwachenden Schaltschrankes anzuordnen, wobei mit der Lüftereinheit die repräsentativen Luftproben aus dem Kühlluftstrom des Schaltschrankes entnommen werden.

Problematisch bei einer solchen Lösung ist allerdings zum einen die relativ große Bauhöhe des Branderkennungssystems. Zum anderen ist es häufig aus verschiedenen Gründen nicht oder nur mit großem Aufwand möglich, das Branderkennungssystem auf der Gehäusedecke des zu überwachenden Schaltschrankes anzuordnen. Oftmals nämlich steht bei Schaltschränken nicht der notwendige Einbauraum oberhalb der Gehäusedecke zur Verfügung, um ein solches System zu installieren. Dies hat zur Folge, dass ein nachträgliches Umrüsten eines Schaltschrankes mit einem Branderkennungssystem nur mit größerem baulichen Aufwand und unter Umständen gar nicht möglich ist. Ferner kann durch ein auf der Gehäusedecke installiertes Branderkennungssystem häufig nicht eine hinreichende Wärmeabfuhr der in dem Schaltschrank integrierten elektronischen bzw. elektrischen Bauteile sichergestellt werden, so dass die Funktionsfähigkeit der in dem Schaltschrank eingesetzten Komponenten beeinflusst wird. Auch eignet sich das bekannte Branderkennungssystem nur bedingt zum zeitgleichen Überwachen mehrere separate Schaltschränke.

Vor dem Hintergrund dieser Problemstellung ist es eine Aufgabe der vorliegenden Erfindung, eine Vorrichtung zur Branderkennung in Schaltschränken der eingangs genannten Art anzugeben, bei der ein optimaler Schutz des zu überwachenden Schaltschrankes unabhängig von der räumlichen Dimension des Schaltschrankes und des zwischen der Gehäusedecke des Schaltschrankes und der Raumdecke zur Verfügung stehenden Platzes bereitzustellen. Insbesondere soll die erfindungsgemäße Lösung möglichst flexibel und kostengünstig einsetzbar sein, wobei ein nachträgliches Umrüsten eines Schaltschrankes mit einem Branderkennungssystem ohne bauliche Maßnahmen und dennoch möglichst kostengünstig durchführbar ist.

Diese Aufgaben werden bezüglich der eingangs genannten Vorrichtung zur Branderkennung in Schaltschränken erfindungsgemäß dadurch gelöst, dass das Brandfrüherkennungsmodul als Einschub-Rack zum Einschieben in den zu überwachenden Schaltschrank ausgeführt ist und dass das Einschub-Rack einen Steckanschluss aufweist, über den die zumindest eine als modulares Bauteil ausgeführte Detektionseinheit mit dem Ansaugrohrsystem selbständig verbunden wird, wenn das Einschub-Rack in den Schaltschrank eingesetzt ist.

Die erfindungsgemäße Lösung weist erhebliche Vorteile gegenüber dem bekannten und vorstehend erläuterten Branderkennungssystem auf. Zum einen ist ein separates Ansaugrohrsystem vorgesehen, welches platzsparend in dem zu überwachenden Schaltschrank integriert werden kann, und welches über zumindest eine Ansaugöffnung, die in vorteilhaftet Weise im Deckenbereich des Schaltschrankes angeordnet ist, mit dem zu überwachenden Schaltschrank kommuniziert, d.h. in Fluidkommunikation steht. Über dieses Ansaugrohrsystem werden aus dem Schaltschrank repräsentative Luftproben entnommen und dem Brandfrüherkennungsmodul bzw. der in dem Brandfrüherkennungsmodul vorgesehenen zumindest einen Detektionseinheit zugeführt Dadurch, dass erfindungsgemäß ferner das Brandfrüherkennungsmodul als Einschub-Rack ausgebildet ist, welches in den zu überwachenden Schaltschrank eingesetzt werden kann, entfällt bei der erfindungsgemäßen Lösung ein externer Anbau des Branderkennungssystems an dem zu überwachenden Schaltschrank. Somit kann das Brandfrüherkennungssystem gemäß der vorliegenden Erfindung vollkommen unabhängig von dem in der Umgebung des zu überwachenden Schaltschrankes zur Verfügung stehenden Raum in dem Schaltschrank eingesetzt werden. Dies ermöglicht insbesondere auch ein besonders kostengünstiges und einfach zu realisierendes, nachträgliches Umrüsten eines Schaltschrankes mit einem Brandfrüherkennungssystem.

Des weiteren ist ein Vorteil darin zu sehen, dass die wesentlichen Bauteile der erfindungsgemäßen Schaltschrank-Branderkennungsvorrichtung, und insbesondere die zumindest eine Detektionseinheit, als modulare Bauteile ausgeführt sind. Als "modular" im Sinne der vorliegenden Erfindung werden insbesondere solche funktionellen Bauteile angesehen, die im "Baukastenprinzip" zu dem als Einschub-Rack ausgeführten Brandfrüherkennungsmodul bei Bedarf hinzugefügt bzw. entfernt werden können, ohne dass dies eine umfangreiche Umstrukturierung des Layouts der Branderkennungsvorrichtung erfordert. Somit liegt es auf der Hand, dass die erfindungsgemäße modulare Ausgestaltung der Branderkennungsvorrichtung insbesondere eine kundenspezifische Lösung vereinfacht.

Vorteilhafte Weiterentwicklungen der erfindungsgemäßen Vorrichtung zur Branderkennung in Schaltschränken sind in den Unteransprüchen angegeben.

So ist in einer bevorzugten Realisierung der erfindungsgemäßen Lösung vorgesehen, dass das Einschub-Rack ein Standard-Rack mit einer Gesamthöhe von 1 HE ist. Wie auch allgemein in der Veranstaltungs-, Labor- und Regeltechnik wird hierin unter dem Begriff "Rack" bzw. "Einschub-Rack" ein Regal insbesondere für Elektrogeräte mit einer genormten Breite von 19 Zoll verstanden, bei dem die einzelnen Geräte, die sich im Rack montieren lassen, eine Frontplatten-Breite von etwas mehr als 48 cm aufweisen. Eine Höheneinheit (1HE) ist mit 1,75 Zoll (4,45 Zentimetern) spezifiziert. Ein Standard-Rack ist ein gemäß EIA 310-D, IEC 60297 und DIN 41494 SC48D genormtes 19"-Rack, wodurch der Einbau beliebiger Geräte möglich ist, so lange diese auch den genannten Normen entsprechen. Standard-Racks für Server in Rechenzentren bieten bei einer Höhe von 2 Metern meist einen Netto-Raum von 42 HE, wobei es aber Schrank-Typen mit unterschiedlichen Bautiefen ebenso gibt, wie Versionen mit seitlichem Zusatzraum für die Verkabelung.

Dadurch, dass bei der erfindungsgemäßen Vorrichtung ein aspirativ arbeitendes Brandfrüherkennungsmodul zum Einsatz kommt, ist es möglich, die Gesamt-Baugröße und insbesondere Bauhöhe der Vorrichtung zu minimieren, wodurch in vorteilhafter Weise die Branderkennungsvorrichtung in einem 19"-Einschub-Rack mit einer Bauhöhe von nur 4,45 Zentimetern (= 1 HE) integrierbar ist, was insbesondere die Verwendung der Vorrichtung in Schaltschränken erlaubt, ohne dass hierbei der zur Aufnahme von elektrischen Geräten zur Verfügung stehende Einbauraum im Schaltschrank stark eingeschränkt wird.

Gemäß der erfindungsgemäßen Lösung ist ferner vorgesehen, dass das Einschub-Rack einen Steckanschluss aufweist, über den die als modulares Bauteil ausgeführte Detektionseinheit mit dem Ansaugrohrsystem selbständig verbunden wird, wenn das Einschub-Rack in dem Schaltschrank eingesetzt ist. Hierdurch wird eine besonders einfach zu bedienende und modular ausgeführte Lösung bereitgestellt, die ein Austauschen bzw. Nachrüsten eines herkömmlichen Schaltschrankes mit einem solchen Schaltschrank-Branderkennungssystem ermöglicht. Als technische Realisierung des Steckanschlusses kommen verschiedene Lösungen in Frage.

In einer besonders bevorzugten Ausführungsform ist vorgesehen, dass das Ansaugrohrsystem eine Vielzahl von zu überwachenden Schaltschränken verbindet, wobei das Ansaugrohrsystem mit den einzelnen zu überwachenden Schaltschränken über jeweils zumindest eine Ansaugöffnung kommuniziert, und wobei mit Hilfe des Ansaugrohrsystems aus den zu überwachenden Schaltschränken jeweils repräsentative Luftproben entnommen werden, die dem Brandfrüherkennungsmodul zugeführt werden. Gemäß dieser Ausführungsform können demnach eine Vielzahl von Schaltschränken mit einem einzigen als Einschub-Rack ausgebildeten Brandfrüherkennungsmodul überwacht werden. Hierzu ist lediglich erforderlich, dass das Ansaugrohrsystem erweitert wird, d.h. in die zusätzlichen zu überwachenden Schaltschränken verlegt und mit entsprechenden Ansaugöffnungen versehen wird. Selbstverständlich ist aber auch denkbar, mehrere getrennt voneinander wirkende Ansaugrohrsysteme vorzusehen, wobei jedes einzelne Ansaugrohrsystem einen Schaltschrank oder eine Gruppe von Schaltschränken mit dem Brandfrüherkennungsmodul verbindet. Der Vorteil dieser Weiterentwicklung liegt insbesondere darin, dass mit der erfindungsgemäßen Lösung auf besonders einfache Weise auch eine Vielzahl von Schaltschränke mit einem Brandfrüherkennungssystem ausgerüstet oder (nachträglich) mit einem Brandfrüherkennungssystem nachgerüstet werden können, wobei dies besonders kostengünstig und insbesondere ohne bauliche Maßnahmen erzielbar ist.

Um zu erreichen, dass aus dem zu überwachenden Schaltschrank bzw. aus den zu überwachenden Schaltschränken über das Ansaugrohrsystem die jeweiligen Luftprobcn mit der erfindungsgemäßen Branderkennungsvorrichtung selbständig angesaugt werden können, ist in einer besonders bevorzugten Weiterentwicklung vorgesehen, dass das Brandfrüherkennungsmodul ferner ein über die Steuerung ansteuerbares und als modulares Bauteil ausgebildetes Lüftermodul aufweist. Durch den modularen Aufbau des Lüftermoduls, das als separates Bauteil (bei Bedarf) in dem als Einschub-Rack ausgebildeten Brandfrüherkennungsmodul integriert werden kann, wird der einfache und modulare Aufbau der erfindungsgemäßen Vorrichtung beibehalten. Selbstverständlich ist aber auch denkbar, dass die erfindungsgemäße Vorrichtung die Luftproben aus dem Kühlluftkrcislauf des zu überwachenden Schaltschrankes entnimmt, so dass gegebenenfalls auch auf ein separates Lüftermodul verzichtet werden kann.

In einer besonders bevorzugten Weiterentwicklung der zuletzt genannten Ausführungsform, bei welcher ein über die Steuerung ansteuerbares und als modulares Bauteil ausgebildetes Lüftermodul zum Ansaugen der Luftproben aus dem zu überwachenden Schaltschrank bzw. aus den zu überwachenden Schaltschränken über das Ansaugrohrsystem vorgesehen ist, weist das Brandfrüherkennungsmodul ferner ein über die Steuerung ansteuerbares und als separates Bauteil ausgeführtes Ausblasmodul zum Ausblasen der in dem Ansaugrohrsystem angesaugten Luftprobe auf, wobei das Ausblasmodul von der Steuerung aktiviert wird, wenn die zumindest eine Detektionseinheit in den angesaugten Luftproben zumindest eine Brandkenngröße nachweist. Durch das Vorsehen eines Anzeigeelements, das den Brandort in einem der zu überwachenden Schaltschränken identifiziert und/oder durch das Vorsehen einer Kommunikationseinrichtung, über welche Information hinsichtlich der Entstehung und/oder des Vorhandenseins eines Brandes in einem oder in mehreren der zu überwachenden Schaltschränke und hinsichtlich der eindeutigen Lokalisierung des Brandes in dem einen oder in den mehreren zu überwachenden Schaltschränken zu einer von der Vorrichtung bzw. dem Schaltschrank entfernten Stelle übertragen werden kann, eignet sich die erfindungsgemäße Lösung insbesondere auch zum genauen Lokalisieren eines Brandes in dem Fall, wenn mehrere Schaltschränke mit der erfindungsgemäßen Vorrichtung überwacht werden.

Mit dieser bevorzugten Weiterentwicklung, mit welcher somit eine Lokalisierung eines Brandes in einem der mehreren zu überwachenden Schaltschränken ermöglicht wird, ist eine besonders einfache und kostengünstige Nachrüstung zur Einzelerkennung von Brandherden oder Gasverunreinigungen unter den Gesichtspunkten bestehender Normen technisch möglich. Der Vorteil dieser Ausführungsform liegt insbesondere darin, dass nicht nur die Forderungen nach einfacher Nachrüstung eines Schaltschrankes bei gleichzeitig geringen Betriebskosten durch ein besonders einfach zu realisierendes und dabei sehr effektives Verfahren zur Erkennung und Lokalisierung des Brandes und/oder der Entstehung des Brandes in einem aus einer Vielzahl von zu überwachenden Schaltschränken erzielbar ist, sondern sich auch Dank der Lokalisierung des Brandortes über die vorteilhafte Ausführungsform der erfindungsgemäßen Vorrichtung neue Anwendungen für Schaltschrank-Brandüberwachungseinheiten eröffnet. So kann insbesondere nun auf eine Vielzahl einzelner Brandmelder verzichtet werden, die ansonsten zur Überwachung von mehreren Schaltschränken in den einzelnen Schaltschränken eingesetzt werden müssen.

Durch die Tatsache, dass die Branderkennung und die Brandlokalisierung auf einem aspirativen Funktionsprinzip basiert, ist dieses Funktionsmerkmal der erfindungsgemäßen Schaltschrank-Branderkennungsvorrichtung äußerst sensibel und insbesondere unabhängig im Hinblick auf beispielsweise Luftturbulenzen, die aufgrund der zur Kühlung eingesetzten Lüfter in den einzelnen Schaltschränken hervorgerufen wird. Durch das Ausblasen der angesaugten und sich im Ansaugrohrsystem befindlichen Luftproben, nachdem zumindest eine Brandkenngröße in der über das Ansaugrohrsystem angesaugten Luftprobe mit der zumindest einen Detektionseinheit nachgewiesen wurde, wird erreicht, dass sich dann in dem gesamten Ansaugrohrsystem Frischluft befindet, das heißt Luft, die mit Sicherheit keine Brandkenngröße mehr aufweist.

Denkbar wäre auch, dass die Steuerung gezielt denjenigen Schaltschrank abschaltet und/oder ein Signal zum Fluten des Schaltschrankes mit Löschmitteln abgibt, wenn in dem betreffenden Schaltschrank der Brandort lokalisiert wurde. Allgemein ist es bevorzugt, dass das Brandfrüherkennungsmodul ausgelegt ist, in Erwiderung auf ein mit der zumindest einen Detektionseinheit ausgegebenes Nachweisergebnis über die Steuerung ein Brandfrüherkennungssignal auszugeben, mit welchem die Energiezufuhr des zu überwachenden Schaltschranks bzw. der zu überwachenden Schaltschränke abgeschaltet wird.

In einer weiteren vorteilhaften Realisierung der erfindungsgemäßen Vorrichtung, die zur Lokalisierung eines Brandortes ausgelegt ist, ist vorgesehen, dass das Lüftermodul und das Ausblasmodul gemeinsam als ein Gebläse ausgebildet sind, das seine Luftförderrichtung in Erwiderung auf ein Steuersignal von der Steuerung ändert. Hierdurch kann erreicht werden, dass die Anzahl der die erfindungsgemäße Vorrichtung begründenden Komponenten weiter reduziert werden kann, was in vorteilhafter Weise wiederum die Kosten der Herstellung der erfindungsgemäßen Vorrichtung herabsetzt.

Um die Anzahl der Komponenten, die die erfiridungsgemäße Branderkennungs- und Brandlokalisierungsvorrichtung ausbilden, weiter zu reduzieren, ist das als Gebläse ausgebildete Lüftermodul in vorteilhafter Weise ein Lüfter mit Drehrichtungsumkehr.

In einer weiteren Realisierung der zuletzt genannten erfindungsgemäßen Vorrichtung, bei der das Lüftermodul und das Ausblasmodul gemeinsam als ein Gebläse ausgebildet sind, ist vorgesehen, dass das Gebläse ein Lüfter mit Lüftungsklappen zur Änderung der Luftförderrichtung ist. Selbstverständlich sind hier aber auch andere Ausführungsformen denkbar.

Um zu erreichen, dass die erfindungsgemäße Branderkennungsvorrichtung zusätzlich auch als Vorrichtung zur Brandlöschung in Schaltschränken eingesetzt werden kann, ist in einer bevorzugten Weiterbildung der Erfindung ferner eine über die Steuerung ansteuerbare Löschgaseinrichtung vorgesehen, die nach Erkennen einer Brandkenngröße Löschgas in den zu überwachenden Schaltschrank bzw. in die zu überwachenden Schaltschränke einleitet, wobei die Löschgaseinrichtung als modulares Bauteil in dem Brandfrüherkennungsmodul integriert oder als separates Einschub-Rack ausgeführt ist. Die Vorteile dieser Ausführungsform liegen auf der Hand: Demnach bietet diese Lösung nicht nur eine optimale Überwachung sondern zusätzlich einen optimalen Schutz der zu überwachenden Schaltschränken, und zwar unabhängig von der räumlichen Dimension des Schaltschrankes und des zwischen der Gehäusedecke des Schaltschrankes und der Raumdecke zur Verfügung stehenden Platzes. Insbesondere ist die erfindungsgemäße Lösung, bei welcher neben der Branderkennung auch eine Brandlöschung mit dem Schaltschranksystem bereitgestellt wird, äußerst flexibel und kostengünstig einsetzbar, wobei ein nachträgliches Umrüsten eines Schaltschrankes mit einem solchen Branderkennungs- und Brandbekämpfungssystem ohne bauliche Maßnahmen und vor allem kostengünstig durchführbar ist.

In einer bevorzugten Realisierung der zuletzt genannten Ausführungsform, bei welcher die erfindungsgemäße Vorrichtung eine über die Steuerung ansteuerbare Löschgaseinrichtung aufweist, ist vorgesehen, dass die Löschgaseinrichtung im Sockel des zu überwachenden Schaltschrankes bzw. in zumindest einem Sockel der zu überwachenden Schaltschränke, vorzugsweise in Gestalt von Löschmittelflaschen, angeordnet ist. Diese Lösung ist besonders platzsparend.

Unter dem Begriff "Löschgas" sind vorliegend sowohl chemische Löschgase, wie beispielsweise FM 200 oder Novec 1230, als auch sämtliche Inertgase zu verstehen, deren Löschwirkung bekanntlich auf einer Reduzierung des Sauerstoffanteils der Luft am Brandort beruht. Während sich die Umgebungsluft üblicherweise aus ca. 48 % Stickstoff, 20 % Sauerstoff, ∼ 1 % Argon und 0,03% Kohlendioxid zusammensetzt, wird diese Zusammensetzung in einem Brandfall oder - zur Minderung des Risikos der Entstehung eines Brandes - fortwährend durch Zugabe eines Löschgases dahingehend verändert, dass der Sauerstoffanteil auf einen Wert unter 15 Vol.-% sinkt. Als Intertgas-Löschmittel kommen je nach Anwendungsfall im wesentlichen Stickstoff, Argon und Kohlendioxid zum Einsatz. Während Argon wegen seiner im Vergleich zu Stickstoff und trockener Umgebungsluft recht hohen Dichte vorzugsweise nur bei Teilbereichsflutungen eingesetzt wird (z.B. in Doppelböden), kommt Kohlendioxid als traditionelles Löschmittel für nicht umschlossene Einrichtungen eine besondere Bedeutung zu. In geschlossenen Räumen ist bei der Anwendung von Kohlendioxid wegen seiner Toxizität Vorsicht geboten. Das Hauptanwendungsgebiet von Stickstoff liegt in der Raumflutung sowie der Flutung umschlossene Einrichtungen. Deshalb ist Stickstoff in den meisten Fällen das optimale Löschmittel.

In einer besonders bevorzugten Realisierung der erfindungsgemäßen Vorrichtung, die neben der Branderkennung auch die Funktion der Brandbekämpfung aufweist, ist vorgesehen, dass die Löschgaseinrichtung einen Löschgasgenerator aufweist, der im Brandfall über eine chemische Reaktion, insbesondere über eine vorab festgelegte Oxidation von Brennstoffmaterialien, ein gasförmiges Löschmittel erzeugt. Mit dieser erfindungsgemäßen Weiterentwicklung muss das Löschmittel nicht mehr in einer Hochdruckgasflasche gelagert werden, sondern wird im Brandfall erst erzeugt. Dies reduziert insbesondere die räumliche Dimension der Löschgaseinrichtung in erheblichen Maßen, so dass die Löschgaseinrichtung problemlos als modulares Bauteil in dem Brandfrüherkennungsmodul selber integriert oder als separates Einschub-Rack ausgeführt werden kann, wobei im letzteren Fall das Einschub-Rack der Löschgaseinrichtung nur noch eine geringe Bauhöhe aufweist.

Alternativ oder zusätzlich zu der zuletzt genannten bevorzugten Realisierung kann die Löschgaseinrichtung aber auch einen Aerosolgenerator aufweisen, der dahingehend ausgelegt ist, dass mittels einer im Brandfall ausgelösten chemischen Reaktion Löschgase, insbesondere Stickstoff, Wasser und Kaliumverbindungen, erzeugt werden.

Mit den beiden die Löschgaseinrichtung betreffenden vorteilhaften Realisierungen, kann ein in einem der zu überwachenden Schaltschränken ausgebrochenes und mittels der zumindest einen Detektionseinheit erkanntes Feuer schnell und effizient gelöscht werden. Insbesondere ist die auf einem Löschgasgenerator oder auf einem Aerosolgenerator basierende Brandbekämpfung äußerst umweltfreundlich. Der Reaktionsverlauf des Löschprozesses, welche vorzugsweise auf Kaliumverbindungen oder Inertgase basiert, garantiert eine Brandbekämpfung praktisch ohne die üblichen Folgeschäden, die durch Wasser oder Schaum hervorgerufen werden. Insbesondere bei der Brandbekämpfung in Schaltschränken, in denen elektrische und/oder elektronische Bauteile beherbergt sind, hätten solche Folgeschäden unter Umständen verheerende Auswirkungen. Auch führt eine auf Wasser oder Schaum basierende Brandbekämpfung häufig zu Umweltverunreinigungen.

Wie bereits erwähnt, kann insbesondere durch die Verwendung eines Löschgasgenerators oder Aerosolgenerators als Löschgaseinrichtung die Bauhöhe der erfindungsgemäßen Vorrichtung, die ferner die Funktionalität der Brandbekämpfung aufweist, verringert werden.

Um zu erreichen, dass die zuvor angegebenen vorteilhaften Weiterentwicklungen der erfindungsgemäßen Schaltschrank-Vorrichtung, bei denen neben der Funktionalität der Branderkennung auch die Funktionalität der Brandbekämpfung vorgesehen sind, möglichst störungsunabhängig und genau arbeiten, und somit eine zuverlässige Branderkennung und Brandbekämpfung möglich wird, ist in bevorzugter Weise ferner eine temperaturgesteuerte Zündeinrichtung zum Auslösen der Löschgaseinrichtung bei Überschreiten einer festlegbaren Temperatur vorgesehen.

Um eine möglichst optimale Verteilung des im Brandfall mit der Löschgaseinrichtung erzeugten Löschmittels in den einzelnen zu überwachenden Schaltschränken zu ermöglichen, und um zu erreichen, dass das Löschmittel (bei Bedarf) gezielt in einen bestimmten Schaltschrank oder in eine Gruppe bestimmter Schaltschränke eingeleitet werden kann, weist die erfindungsgemäße Vorrichtung, die zusätzlich zur Branderkennung auch zur Brandbekämpfung ausgelegt ist, in einer vorteilhaften Ausführungsform ferner ein Löschgas-Zufuhrrohrsystem auf, welches die Löschgaseinrichtung mit den zu überwachenden Schaltschränken verbindet, und über welches im Brandfall das von der Löschgaseinrichtung erzeugte Löschgas zu den einzelnen Schaltschränken geführt werden kann. Selbstverständlich ist aber auch denkbar, dass jeder einzelne zu überwachende Schaltschrank mit einem separaten Löschgas-Zufuhrrohrsystem verbunden ist, um eine gezielte Zufuhr von Löschmittel in den einzelnen Schaltschränken zu ermöglichen.

Im Hinblick auf die Ausfallsicherheit der erfindungsgemäßen Lösung ist schließlich bevorzugt vorgesehen, dass die Vorrichtung eine Vielzahl parallel arbeitende Brandfrüherkennungsmodule mit jeweils einer Detektionseinheit und einer vorzugsweise gemeinsamen Steuerung aufweist bzw. ein Brandfrüherkennungsmodul mit einer Steuerung und einer Vielzahl parallel arbeitender Detektionseinheiten aufweist, wobei die Steuerung ausgelegt ist, in Abhängigkeit von jedem der mit den jeweiligen Detektionseinheiten ausgegebenen Nachweisergebnisse ein Brandfrüherkennungssignal auszugeben, um die Stromzufuhr des zu überwachenden Schaltschranks bzw. der zu überwachenden Schaltschränke abzuschalten und/oder eine Löschgaseinrichtung anzusteuern, um Löschgas in den zu überwachenden Schaltschrank bzw. in die zu überwachenden Schaltschränke einzuleiten. Insbesondere wäre es hierbei denkbar, dass die Steuerung ausgelegt ist, ein Brandfrüherkennungssignal auszugeben, wenn jedes der mit den jeweiligen Detektionseinheiten ausgegebenen Nachweisergebnisse auf einen Brand hinweist.

Die erfindungsgemäße Vorrichtung zeichnet sich insbesondere durch ihren modularen Aufbau aus. In einer vorteilhaften Weiterentwicklung der erfindungsgemäßen Schaltschrank-Branderkennungs- und/oder Schaltschrank-Brandbekämpfungsvorrichtung ist vorgesehen, dass das Brandfrüherkennungsmodul eine Vielzahl von Aufnahmeelementen zur Aufnahme der als separate Bauteile ausgeführten und in dem Brandfrüherkennungsmodul vorgesehenen Module aufweist, wobei die in dem Brandfrüherkennungsmodul vorgesehenen und als separate Bauteile ausgeführte Module insbesondere als Steckmodule ausgelegt sind, die in die Aufnahmeelemente eingesetzt werden können. Dieses ermöglicht den Aufbau der erfindungsgemäßen Vorrichtung nach dem Baukastenprinzip, was zum einen die Herstellungskosten der erfindungsgemäßen Vorrichtung reduziert und zum anderen eine anwenderspezifische Lösung in effektiver und leicht zu realisierender Weise ermöglicht.

Im folgenden werden bevorzugte Ausführungsformen der erfindungsgemäßen Vorrichtung anhand der Figuren näher beschrieben.

Es zeigen:
- Fig. 1: eine schematische Ansicht einer bevorzugten ersten Ausführungsform der erfindungsgemäßen Vorrichtung im installierten Zustand, wobei die Vorrichtung als Schaltschrank-Branderkennungsvorrichtung ausgeführt ist;
- Fig. 2: eine schematische Ansicht einer zweiten bevorzugten Ausführungsform der erfindungsgemäßen Vorrichtung im installierten Zustand, wobei die Vorrichtung als Schaltschrank-Branderkennungsvorrichtung mit der zusätzlichen Funktionalität der Temperaturerfassung bzw. Temperaturüberwachung ausgeführt ist;
- Fig. 3: eine schematische Ansicht einer dritten bevorzugten Ausführungsform der erfindungsgemäßen Vorrichtung im installierten Zustand wobei die Vorrichtung als Schaltschrank-Branderkennungsvorrichtung mit den zusätzlichen Funktionalitäten der Temperaturerfassung und Brandbekämpfung ausgeführt ist;
- Fig. 4a: eine perspektivische teilgeschnittene Ansicht eines Einschub-Racks, in welchem eine bevorzugte Ausführungsform des Brandfrüherkennungsmoduls eingebauten ist;
- Fig. 4b: eine perspektivische teilgeschnittene Ansicht eines Einschub-Racks, in welchem eine bevorzugte Ausführungsform des Brandfrüherkennungsmoduls mit zwei Detektionseinheiten eingebauten ist;
- Fig. 5: eine perspektivische Ansicht des Einschub-Racks gemäß Fig. 4a in einem geschlossenen Zustand;
- Fig. 6: eine erste mögliche Ausführungsform des Brandfrüherkennungsmoduls in separater Darstellung;
- Fig. 7: eine zur ersten in Fig. 6 dargestellten Ausführungsform alternative zweite bevorzugte Ausführungsform des Brandfrüherkennungsmoduls in separater Darstellung;
- Fig. 8: eine perspektivische Ansicht einer modular ausgeführten und in dem Brandfrüherkennungsmodul gemäß Fig. 7 eingesetzten Detektionseinheit in separater Darstellung;
- Fig. 9: eine perspektivische Ansicht eines modular ausgeführten und in dem Brandfrüherkennungsmodul gemäß Fig. 7 eingesetzten Lüfter-/Ausblasmoduls in separater Darstellung;
- Fig. 10: eine perspektivische Ansicht eines modular ausgeführten und in dem Brandfrüherkennungsmodul gemäß Fig. 7 eingesetzten Filtermoduls in separater Darstellung; und
- Fig. 11: eine perspektivische Ansicht eines modular ausgeführten und in dem Brandfrüherkennungsmodul gemäß Fig. 7 eingesetzten Luftstromüberwachungsmoduls in separater Darstellung.

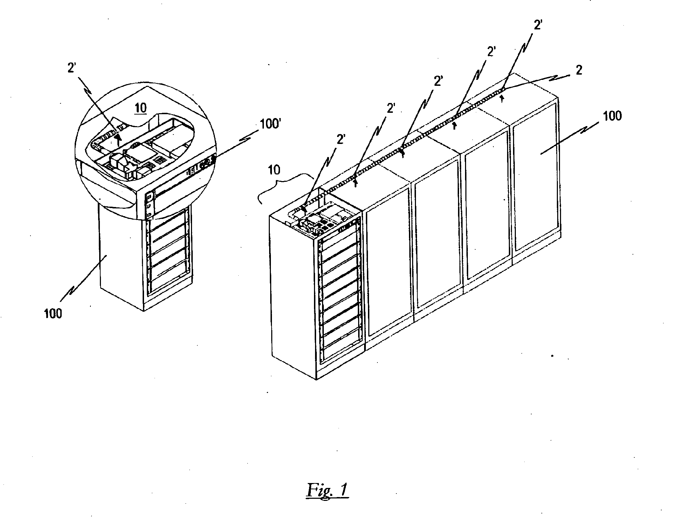

Fig. 1 zeigt eine schematische Ansicht einer bevorzugten ersten Ausführungsform der erfindungsgemäßen Vorrichtung im installierten Zustand, wobei die Vorrichtung als Schaltschrank-Branderkennungsvorrichtung ausgeführt ist. Die Schaltschrank-Branderkennungsvorrichtung weist ein Ansaugrohrsystem 2 auf, welches eine Vielzahl benachbart angeordneter Schaltschränke 100 (in der dargestellten Ausführungsform insgesamt fünf Schaltschränke 100) verbindet, wobei das Ansaugrohrsystem 2 mit den einzelnen zu überwachenden Schaltschränken 100 über jeweils eine Ansaugöffnung 2' kommuniziert. Des weiteren weist die Branderkennungsvorrichtung gemäß dieser Ausführungsform ein Brandfrüherkennungsmodul 10 auf, welches eine (nachfolgend beschriebene) Detektionseinheit 1 zum Nachweisen von zumindest einer Brandkenngröße in der über das Ansaugrohrsystem 2 angesaugten Luftprobe und eine Steuerung 12 zur Abgabe eines Brandfrüherkennungssignals in Erwiderung auf ein mit der Detektionseinheit 11 ausgegebenes Nachweisergebnis aufweist. Mit Hilfe des Ansaugrohrsystems 2 wird aus den einzelnen zu überwachenden Schaltschränken 100 jeweils repräsentative Luftproben entnommen, die dem als Einschub-Rack 100' zum Einschieben in einen der zu überwachenden Schaltschränken 100 ausgeführten Brandfrüherkennungsmodul 10 zugeführt werden.

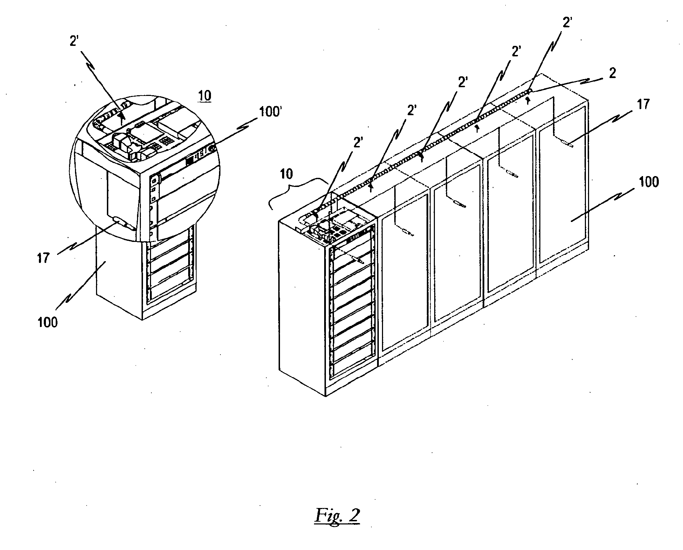

Fig. 2 zeigt eine schematische Ansicht einer zweiten bevorzugten Ausführungsform der erfindungsgemäßen Vorrichtung im installierten Zustand, wobei die Vorrichtung als Schaltschrank-Branderkennungsvorrichtung mit der zusätzlichen Funktionalität der Temperaturerfassung bzw. Temperaturüberwachung ausgeführt ist. Diese Ausführungsform unterscheidet sich von der in Fig. 1 gezeigten Ausführungsform dadurch, dass hier zur Verbesserung der Branderkennung in den einzelnen Schaltschränken 100 Temperatursensoren 17 integriert sind. Die Temperatursensoren 17 werden über eine gemeinsame Leitung dem Brandfrüherkennungsmodul 10 bzw. der in dem Brandfrüherkennungsmodul 10 vorgesehenen Steuerung 12 zugeführt. Selbstverständlich ist - abweichend von der in Fig. 2 dargestellten Ausführungsform - auch denkbar, dass nicht jeder einzelne Schaltschrank 100 mit einem Temperatursensor 17 ausgerüstet ist.

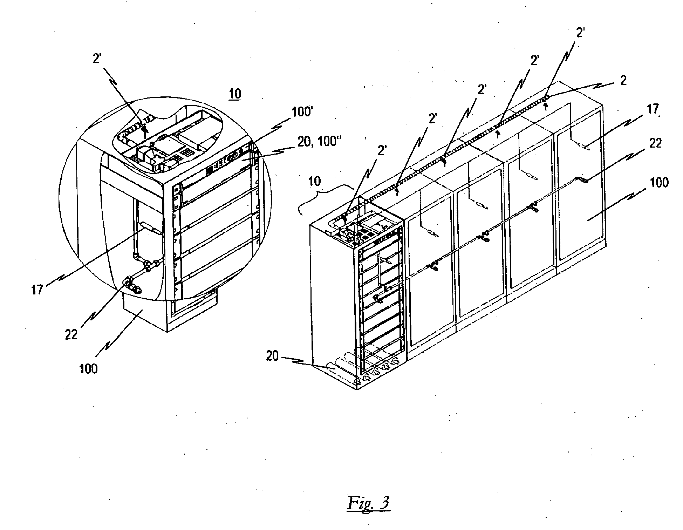

Fig. 3 zeigt eine schematische Ansicht einer dritten bevorzugten Ausführungsform der erfindungsgemäßen Vorrichtung im installierten Zustand, wobei die Vorrichtung als Schaltschrank-Branderkennungsvorrichtung mit den zusätzlichen Funktionalitäten der Temperaturerfassung und Brandbekämpfung ausgeführt ist. Diese Ausführungsform unterscheidet sich von der zweiten bevorzugten Ausführungsform gemäß Fig. 2 dadurch, dass die Schaltschrank-Branderkennungsvorrichtung hier neben der Funktion der Branderkennung auch die Funktion der Brandbekämpfung aufweist. Hierzu ist eine (nicht explizit dargestellte) Löschgaseinrichtung 20 in der Gestalt eines zusätzlichen Einschub-Racks 100" unterhalb des ebenfalls als Einschub-Rack 100' ausgebildeten Brandfrüherkennungsmoduls 10 in dem einen der zu überwachenden Schaltschränke 100 eingesetzt.

Ferner ist hier ein Löschgas-Zufuhrrohrsystem 22 vorgesehen, welches sich zwischen der als Einschub-Rack 100" ausgebildeten Löschgaseinrichtung 20 und den einzelnen zu überwachenden Schaltschränken 100 erstreckt. Über dieses Löschgas-Zufuhrrohrsystem 22 wird im Brandfall ein in der Löschgaseinrichtung 20 erzeugtes Löschmittel den einzelnen Schaltschränken 100 zugeführt. Optional ist denkbar, dass die Löschgaseinrichtung 20 nicht (wie dargestellt) als separates Einschub-Rack 100" ausgeführt, sondern als modulares Bauteil in dem Brandfrüherkennungsmodul 10 integriert ist.

Die erfindungsgemäße Schaltschrank-Branderkennungsvorrichtung gemäß Fig. 3, die neben der Funktionalität der Branderkennung ebenfalls die Funktionalität der Brandbekämpfung aufweist, ist - wie bereits erwähnt - mit der Löschgaseinrichtung 20 ausgerüstet, die als modulares Bauteil in dem Brandfrüherkennungsmodul 10 bzw. in dem zum Brandfrüherkennungsmodul 10 zugehörigen Einschub-Rack 100' integriert oder als separates Einschub-Rack ausgeführt ist. Dabei ist bevorzugt vorgesehen, dass die Löschgaseinrichtung 20 einen (nicht explizit dargestellten) Löschgasgenerator aufweist, der im Brandfall über eine chemische Reaktion ein gasförmiges Löschmittel erzeugt. Anders ausgedrückt bedeutet dies, dass bei der erfindungsgemäßen Vorrichtung gemäß Fig. 3 kein Löschmittel, etwa in Hochdruckgasflaschen, gelagert werden muss, was die Abmessungen und Dimensionen der gesamten Schaltschrank-Branderkennungsvorrichtung reduziert. Denkbar dabei wäre, dass im Brandfall in der Löschgaseinrichtung 20 eine chemischen Reaktion ausgelöst wird, bei der Stickstoff, Wasser und Kaliumverbindungen produziert werden. Dabei wird der Verbrennungsvorgang durch die katalytisch ausgelöste Reaktion gestoppt. Alternativ oder zusätzlich hierzu ist auch denkbar, dass in der Löschgaseinrichtung 20 als Treibsatz stickstoffreiche organische Brennstoffe in Kombination mit ausgewählten Oxidaturen und Katalysatoren verwendet werden. Diese beispielsweise in Form von Tabletten gepressten Brennstoffe werden dann beim Detektieren eines Brandes in einem der zu überwachenden Schaltschränke 100 angezündet, die innerhalb kurzer Zeit ein gasförmiges Löschmittel erzeugen, welches über das Löschgas-Zufuhrrohrsystem 22 zu dem Schaltschrank 100 zugeführt wird.

In einer besonders bevorzugten Weiterentwicklung, die allerdings nicht in den Figuren dargestellt ist, sind Einrichtungen zum Selbstaktivieren der Löschgaseinrichtung 20 vorgesehen, so dass bei Beginn eines Feuers ein sofortiger Löschprozess ausgelöst werden kann. Denkbar hierbei wäre beispielsweise, dass sich die Löschgaseinrichtung 20 bei Wärmeentwicklung selbst aktiviert und das ausbrechende Feuer schnell und effizient löscht. Ein auf Hitzeeinwirkung basierendes Aktivieren der Löschgaseinrichtung 20 kann ferner beispielsweise mittels der Temperatursensoren 17 bewirkt werden.

Der Vorteil der in der erfindungsgemäßen Vorrichtung gemäß Fig. 3 optional eingesetzten Löschgaseinrichtung 20, bei welcher Aerosol-Generatoren bzw. Löschgasgeneratoren verwendet werden, ist insbesondere in der hohen Lagerstabilität und Langlebigkeit des Systems zu sehen, da dieses keine Druckbehälter zur Lagerung von Löschmitteln aufweist und insbesondere autonom und automatisch funktioniert. Ferner entfällt eine Druckversorgung oder eine externe Stromversorgung, so dass eine zusätzliche Wartung dieser Systeme nicht mehr notwendig ist.

Neben der bereits erwähnten wärmebasierenden Selbstaktivierung der Löschgaseinrichtung 20 ist auch denkbar, dass diese mit einer temperaturgesteuerten Zündschnur (Thermocord) zur Selbstaktivierung ausgerüstet ist. Diese temperaturgesteuerte Zündschnur sollte dabei derart ausgelegt sein, dass sie die Löschgaseinrichtung 20 aktiviert, sobald eine vorab festlegbare Temperatur erreicht ist. Nach der Auslösung des Löschvorganges verteilt sich das in der Löschgaseinrichtung 20 erzeugte Löschmittel über das Löschgas-Zufuhrrohrsystem 22 auf das zu löschende Gut. Selbstverständlich sind aber auch andere Verfahren zum Auslösen der Löschgaseinrichtung 20 denkbar. Insbesondere können Aerosolgeneratoren, in denen mittels einer chemischen Reaktion das Löschmittel erzeugt wird, elektrisch, thermisch oder auch manuell ausgelöst werden. Nach Aktivierung des Systems wird die Kaliumverbindung katalytisch umgewandelt und verteilt sich über das Löschgas-Zufuhrrohrsystem 22 auf das in einem Schaltschrank 100 oder in einer Gruppe von Schaltschränken 100 ausgebrochene und mittels des Brandfrüherkennungsmoduls 10 detektierte Feuer. Insbesondere zeichnen sich Aerosolgeneratoren in ihrer Wirksamkeit und Effizienz aus. So ergibt beispielsweise 1 Gramm festes Kaliumverbindungsmaterial ein Volumen von 1000 mi Aerosol.

In einem Fall, wenn als Löschgaseinrichtung 20 beispielsweise Inertgas-Druckbehälter oder Löschmittelflaschen zum Einsatz kommen, wäre es denkbar, dass die Löschgaseinrichtung 20 auch im Sockel des zu überwachenden Schaltschrankes 100 bzw. in zumindest einem Sockel der zu überwachenden Schaltschränke 100 angeordnet ist, wie es in Fig. 3 angedeutet wird. Selbstverständlich wäre es aber auch denkbar, dass in einem Fall, wenn die Löschgaseinrichtung 20 einen Aerosolgenerator aufweist, diesen im Schaltschranksockel unterzubringen, was eine besonders platzsparende Lösung darstellt.

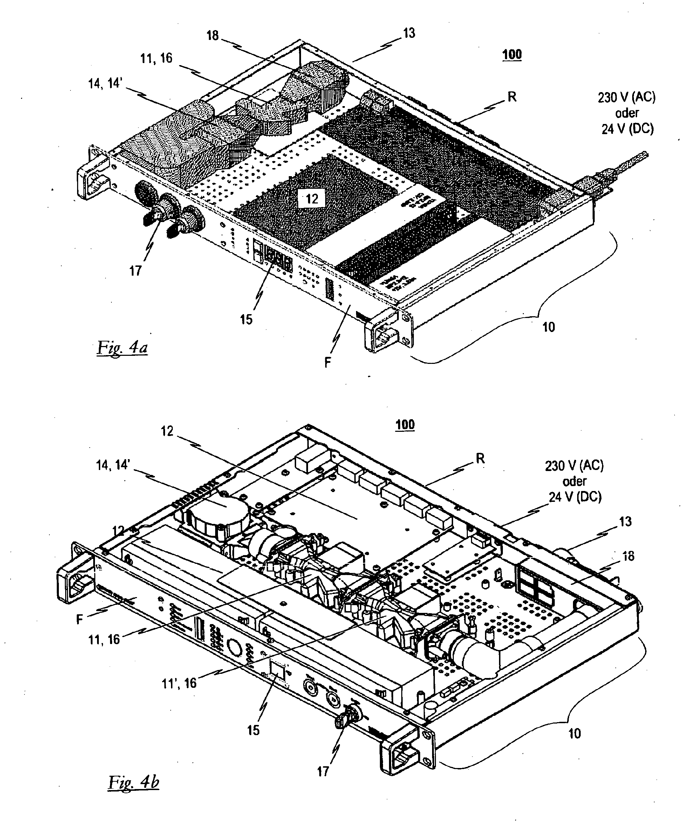

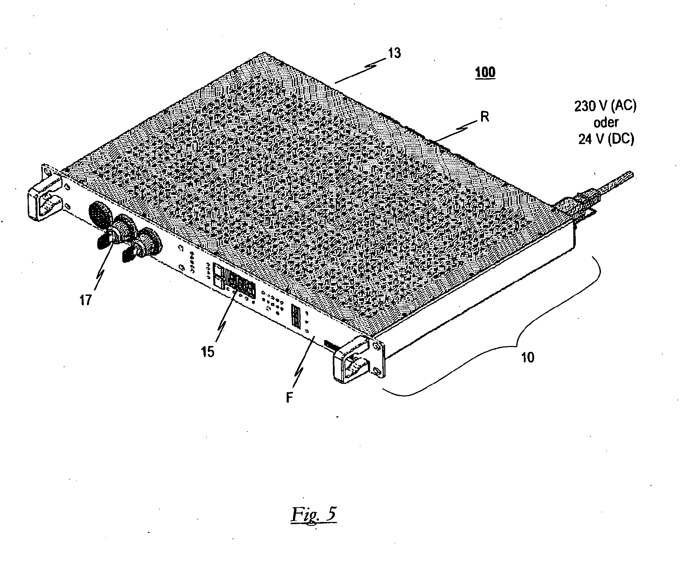

Fig. 4a zeigt eine perspektivische, teilgeschnittene Ansicht eines Einschub-Racks 100', in welchem eine bevorzugte Ausführungsform des Brandfrüherkennungsmodul 10 eingebauten ist. Hingegen zeigt Fig. 5 eine perspektivische Ansicht des Einschub-Racks 100' gemäß Fig. 4a in einem geschlossenen Zustand.

Wie in Fig. 4a dargestellt sind sämtliche Bauteile in dem Einschub-Rack 100' modular zueinander ausgeführt und angeordnet. Im einzelnen weist das Einschub-Rack 100' an seiner Rückseite R einen Steckanschluss 13 auf, über den das Brandfrüherkennungsmodul 10 mit dem (in Fig. 4a nicht explizit dargestellten) Ansaugrohrsystem 2 verbunden wird, wenn - wie es in Fig. 1 bis 3 gezeigt ist - das Einschub-Rack 100' in den Schaltschrank 100 eingesetzt ist. Die über das Ansaugrohrsystem 2 angesaugten Luftproben werden über den Steckanschluss 13 dem Brandfrüherkennungsmodul 10 zugeführt.

Im einzelnen weist das Brandfrüherkennungsmodul 10 in der in Fig. 4a dargestellten Ausführungsform in der Reihenfolge von dem Steckanschluss 13 folgende Bauteile auf: eine Filtereinheit 18, ein Lüfter-/Ausblasmodul 14, 14', ein Luftstromübcrwachungsmodul 16 sowie eine Detektionseinheit 11. Des weiteren ist eine Steuerung 12 vorgesehen, die das Lüfter-/Ausblasmodul 14, 14' steuert und Signale von dem Luftstromüberwachungsmodul 16 sowie der Detektionseinheit 11 empfängt. Die Steuerung 12 wertet diese Signale aus und gibt entsprechende Ausgabesignale an ein an der Frontseite F des Einschub-Racks 100' vorgesehenes Anzeigeelement 15 aus. Über Betätigungsmittel 17, die ebenfalls an der Frontseite F des Einschub-Racks 100' vorgesehen sind, können manuelle Eingaben in die Steuerung 12 eingegeben werden.

Im Brandfall, d.h. wenn die Detektionseinheit 11 in der angesaugten Luftprobe Brandkenngrößen detektiert, gibt die Steuerung 12 ein entsprechendes Signal an das Anzeigeelement 11 sowie optional auch ein entsprechendes Signal an die bei Bedarf vorgesehene und in Fig. 4a nicht explizit dargestellte Löschgaseinrichtung 20 bzw. an eine mit der Löschgaseinrichtung 20 verbundenen Zündeinrichtung ab, um eine Löschgasproduktion zu aktivieren. Alternativ wäre es auch denkbar, dass die Steuerung 12 ein geeignetes Signal an ein entsprechendes ansteuerbares Ventil der bei Bedarf vorgesehenen und in Fig. 4a nicht explizit dargestellten Löschgaseinrichtung 20 abgibt, damit, wenn die Löschgaseinrichtung 20 Druckflaschen mit Inertgas aufweist, das Löschmittel aus den Flaschen ausströmen kann. Der Steuerung 12 werden ebenfalls die Signale der Temperatursensoren 17 (vgl. Fig. 2, 3) zugeführt, die bei der Auswertung der von der Detektionseinheit 11 an die Steuerung 12 abgegebenen Nachweisergebnisse zugrunde gelegt werden oder gegebenenfalls auch als Zündeinrichtung für die optional vorgesehene .Löschgaseinrichtung dienen können.

Optional wäre es hierbei auch denkbar, dass das Brandfrüherkennungsmodule 10 der Schaltschrank-Branderkennungsvorrichtung eine Vielzahl parallel arbeitende Detektionseinheiten 11, 11' und eine gemeinsame Steuerung 12 aufweist, wie es in Fig. 4b angedeutet ist. Hierbei sollte die gemeinsame Steuerung 12 ausgelegt sein, in Abhängigkeit von jedem der mit den jeweiligen Detektionseinheiten 11, 11' ausgegebenen Nachweisergebnisse ein Brandfrüherkennungssignal auszugeben, um die Stromzufuhr des zu überwachenden Schaltschranks 100 bzw. der zu überwachenden Schaltschränke 100 abzuschalten und/oder eine Löschgaseinrichtung 20 anzusteuern, um Löschgas in den zu überwachenden Schaltschrank 100 bzw. in die zu überwachenden Schaltschränke 100 einzuleiten. Bei dieser Ausführungsform wird insbesondere der Ausfallsicherheit des Systems Sorge getragen, da vorzugsweise die gemeinsame Steuerung 12 ausgelegt ist, erst dann ein Brandfrüherkennungssignal auszugeben, wenn jedes der mit den jeweiligen Detektionseinheiten 11, 11' ausgegebenen Nachweisergebnisse auf einen Brand hinweist.

Den Figuren 4a, b und 5 ist insbesondere zu entnehmen, dass das Herzstück der erfindungsgemäßen Schaltschrank-Branderkennungsvorrichtung in einem einzigen Einschub-Rack 100' integriert ist, welches aufgrund seiner geringen Bauhöhe von 1 HE in dem zu überwachenden Schaltschrank 100 problemlos eingesetzt werden kann. Dies erlaubt die Verwendung der Schaltschrank-Branderkennungsvorrichtung in Schaltschränken, ohne dass hierbei der zur Aufnahme von elektrischen Geräten zur Verfügung stehende Einbauraum im Schaltschrank stark eingeschränkt wird. Insbesondere ist von Vorteil, dass mit Hilfe einer optional vorgesehenen Löschgaseinrichtung 20, die beispielsweise in dem als Einschub-Rack 100' ausgeführten Brandfrüherkennungsmodul 10 integriert oder alternativ hierzu als separates Einschub-Rack 100' ausgeführt ist, zusätzlich zur Branderkennung auch eine Brandbekämpfung ermöglicht wird.

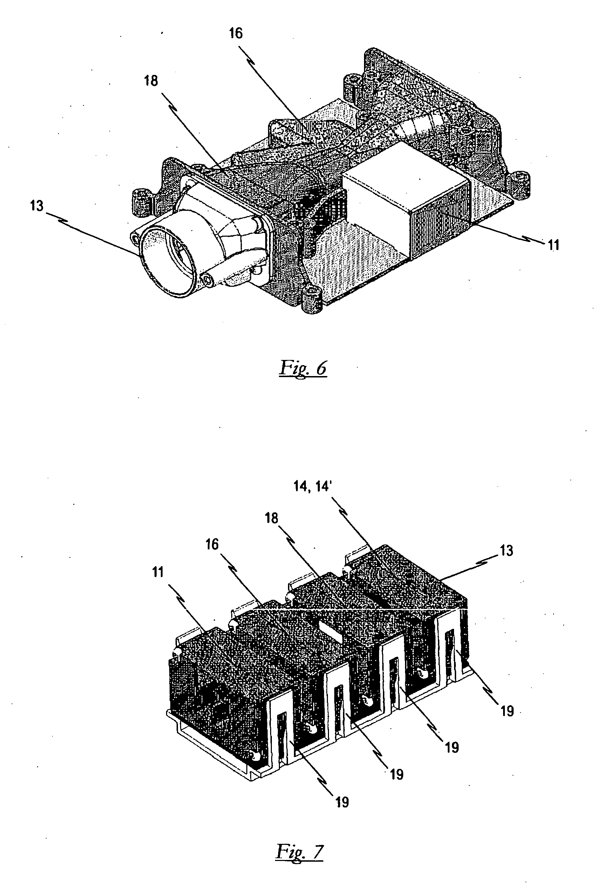

Fig. 6 zeigt eine erste mögliche Ausführungsform der Komponenten "Detektionseinheit 11", "Steckanschluss 13", "Luftstromüberwachungsmodul 16" und "Filtereinheit 18" des Brandfrüherkennungsmoduls 10 in separater Darstellung.

Fig. 7 zeigt eine zur ersten in Fig. 4a, b und 6 dargestellten Ausführungsform alternative zweite bevorzugte Ausführungsform der Komponenten "Detektionseinheit 11", "Lüfter-/Ausblasmodul 14, 14"', "Luftstromüberwachungsmodul 16" und "Filtereinheit 18" des Brandfrüherkennungsmoduls 10 in separater Darstellung. Anhand dieser Ausführungsform ist deutlich der modulare Aufbau des Brandfrüherkennungsmoduls 10 zu erkennen. Im einzelnen sind in Fig. 7 die Filtereinheit 18, das Lüfter-/Ausblasmodul 14, 14', das Luftstromüberwachungsmodul 16 und die Detektionseinheit 11 dargestellt. Sämtliche als modulare Bauteile ausgeführten Module sind in Aufnahmeelementen 19 eingerastet. Hierzu sind an den jeweiligen Modulen entsprechende Rastglieder 19' vorgesehen.

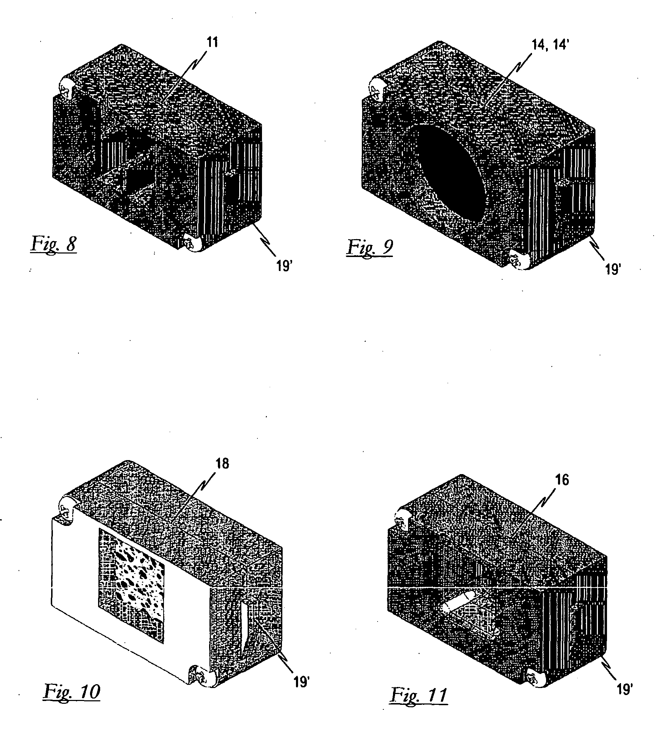

In den Figuren 8 bis 11 sind die in dem Brandfrüherkennungsmodul 10 gemäß Fig. 7 eingesetzten modularen Bauteile einzeln dargestellt. Im einzelnen ist in Fig. 8 die Detektionseinheit 11 gezeigt, welche beispielsweise in der Gestalt einer Rauchdetektionskammer ausgeführt ist. Fig. 9 zeigt das Lüfter-/Ausblasmodul 14, 14', welches mit der Steuerung 12 angesteuert wird, um über das Ansaugrohrsystem 2 die repräsentativen Luftproben aus den zu überwachenden Schaltschränken 100 anzusaugen. Fig. 10 zeigt eine Filtereinheit 18, die zum Schutze der Detektionseinheit 11 optional in dem Brandfrüherkennungsmodul 10 vorgesehen sein kann. Ebenfalls optional kann das in Fig. 11 dargestellte Luftstromüberwachungsmodul 16 vorgesehen sein, um das einwandfreie Funktionieren der Vorrichtung zur Branderkennung und/oder Brandbekämpfung zu überwachen.

Es sei darauf hingewiesen, dass die Ausführung der Erfindung nicht auf die in den Figuren beschriebenen Ausführungsbeispiele beschränkt ist, sondern auch in einer Vielzahl von unter den Schutzumfang der Ansprüche fallenden Varianten möglich ist.

## Patentansprüche

1. Vorrichtung zur Branderkennung in Schaltschränken (100), mit einem Ansaugrohrsystem (2), welches mit dem zu überwachenden Schaltschrank (100) über zumindest eine Ansaugöffnung (2') kommuniziert, und über welches aus dem zu überwachenden Schaltschrank (100) eine repräsentative Luftprobe entnommen wird, und mit einem Brandfrüherkennungsmodul (10), welches zumindest eine Detektionseinheit (11, 11') zum Nachweisen von zumindest einer Brandkenngröße in der über das Ansaugrohrsystem (2) angesaugten Luftprobe und eine Steuerung (12) zur Abgabe eines Brandfrüherkennungssignals in Erwiderung auf ein mit der zumindest einen Detektionseinheit (11, 11') ausgegebenes Nachweisergebnis aufweist,
**dadurch gekennzeichnet, dass**
das Brandfrüherkennungsmodul (10) als Einschub-Rack (100') zum Einschieben in den zu überwachenden Schaltschrank (100) ausgeführt ist, und dass
das Einschub-Rack (100') einen Steckanschluss (13) aufweist, über den die zumindest eine als modulares Bauteil ausgeführte Detektionseinheit (11, 11') mit dem Ansaugrohrsystem (2) selbständig verbunden wird, wenn das Einschub-Rack (100') in den Schaltschrank (100) eingesetzt ist.

2. Vorrichtung nach Anspruch 1, wobei das Einschub-Rack (100') ein Standard-Rack mit einer Gesamthöhe von 1 HE ist.

3. Vorrichtung nach einem der vorhergehenden Ansprüche, wobei das Ansaugrohrsystem (2) eine Vielzahl von zu überwachenden Schaltschränken (100) verbindet, wobei das Ansaugrohrsystem (2) mit den einzelnen zu überwachenden Schaltschränken (100) über jeweils zumindest eine Ansaugöffnung (2') kommuniziert, und wobei mit Hilfe des Ansaugrohrsystems (2) aus den zu überwachenden Schaltschränken (100) jeweils repräsentative Luftproben entnommen werden, die dem Brandfrüherkennungsmodul (10) zugeführt werden.

4. Vorrichtung nach einem der vorhergehenden Ansprüche, wobei das Brandfrüherkennungsmodul (10) ferner ein über die Steuerung (12) ansteuerbares und als modulares Bauteil ausgebildetes Lüftermodul (14) zum Ansaugen der Luftproben aus dem zu überwachenden Schaltschrank (100) bzw. aus den zu überwachenden Schaltschränken (100) über das Ansaugrohrsystem (2) aufweist.

5. Vorrichtung nach Anspruch 4, wobei das Brandfrüherkennungsmodul (10) ferner ein über die Steuerung (12) ansteuerbares und als separates Bauteil ausgeführtes Ausblasmodul (14') zum Ausblasen der in dem Ansaugrohrsystem (2) angesaugten Luftproben aufweist, wobei das Ausblasmodul (14') von der Steuerung (12) aktiviert wird, wenn die zumindest eine Detektionseinheit (11, 11') in den angesaugten Luftproben zumindest eine Brandkenngröße nachweist, und wobei
das Brandfrüherkennungsmodul (10) ferner ein Anzeigeelement (15) aufweist, das den Brandort in einem der zu überwachenden Schaltschränke (100) identifiziert und/oder durch eine Kommunikationseinrichtung Information hinsichtlich der Entstehung und/oder des Vorhandenseins eines Brandes in einem oder mehreren der zu überwachenden Schaltschränke (100) und hinsichtlich der eindeutigen Lokalisierung des Brandes in dem einen oder den mehreren zu überwachenden Schaltschränken (100) zu einer von der Vorrichtung entfernten Stelle überträgt.

6. Vorrichtung nach Anspruch 5, wobei die Steuerung (12) zur zeitlich koordinierten Steuerung des Lüftermoduls (14) und des Ausblasmoduls (14') in Übereinstimmung mit einem von der zumindest einen Detektionseinheit (11, 11') ausgegebenen Signals ausgelegt ist.

7. Vorrichtung nach Anspruch 5 oder 6, wobei das Lüftermodul (14) und das Ausblasmodul (14') gemeinsam als ein Gebläse ausgebildet sind, das seine Luftförderrichtung in Erwiderung auf ein Steuersignal von der Steuerung (12) ändert.

8. Vorrichtung nach Anspruch 7, wobei das als Gebläse ausgebildete Lüftermodul (14) ein Lüfter mit Drehrichtungsumkehr ist.

9. Vorrichtung nach Anspruch 7, wobei das als Gebläse ausgebildete Lüftermodul (14) ein Lüfter mit Lüftungsklappen ist.

10. Vorrichtung nach einem der vorhergehenden Ansprüche, wobei das Brandfrüherkennungsmodul (10) ferner ein über die Steuerung (12) ansteuerbares und als modulares Bauteil ausgeführtes Luftstromüberwachungsmodul (16) zum Überwachen der Luftströmung der über das Ansaugrohrsystem (2) angesaugten Luftproben aufweist.

11. Vorrichtung nach einem der vorhergehenden Ansprüche, wobei das Brandfrüherkennungsmodul (10) ausgelegt ist, in Erwiderung auf ein mit der zumindest einen Detektionseinheit (11, 11') ausgegebenes Nachweisergebnis über die Steuerung (12) ein Brandfrüherkennungssignal auszugeben, mit welchem die Energiezufuhr des zu überwachenden Schaltschranks (100) bzw. der zu überwachenden Schaltschränke (100) abgeschaltet wird.

12. Vorrichtung nach einem der vorhergehenden Ansprüche, wobei die Vorrichtung ferner eine über die Steuerung (12) ansteuerbare Löschgaseinrichtung (20) aufweist, die nach Erkennen einer Brandkenngröße Löschgas in den zu überwachenden Schaltschrank (100) bzw. in die zu überwachenden Schaltschränke (100) einleitet, wobei die Löschgaseinrichtung (20) als modulares Bauteil in dem Brandfrüherkennungsmodul (10) integriert oder als separates Einschub-Rack ausgeführt ist.

13. Vorrichtung nach Anspruch 12, wobei die Löschgaseinrichtung (20) im Sockel des zu überwachenden Schaltschrankes (100) bzw. in zumindest einem Sockel der zu überwachenden Schaltschränke (100), vorzugsweise in Gestalt von Löschmittelflaschen, angeordnet ist.

14. Vorrichtung nach Anspruch 12 oder 13, wobei die Löschgaseinrichtung (20) einen Löschgasgenerator aufweist, der im Brandfall über eine chemische Reaktion, insbesondere über eine vorab festgelegte Oxidation von Brennstoffmaterialien, ein gasförmiges Löschmittel erzeugt.

15. Vorrichtung nach einem der Ansprüche 12 bis 14, wobei die Löschgaseinrichtung (20) einen Aerosolgenerator aufweist, wobei mittels einer im Brandfall ausgelösten chemischen Reaktion Löschgase, insbesondere Stickstoff, Wasser und Kaliumverbindungen, erzeugt werden.

16. Vorrichtung nach einem der Ansprüche 12 bis 15, welche ferner eine temperaturgesteuerte Zündeinrichtung zum Auslösen der Löschgaseinrichtung (20) bei Überschreiten einer festlegbaren Temperatur aufweist.

17. Vorrichtung nach einem der Ansprüche 12 bis 16, wobei die Vorrichtung ferner ein Löschgas-Zufuhrrohrsystem (22) aufweist, welches die Löschgaseinrichtung (20) mit den zu überwachenden Schaltschränken (100) verbindet, und über welches im Brandfall das von der Löschgaseinrichtung (20) erzeugte Löschgas zu den einzelnen Schaltschränken (100) führt.

18. Vorrichtung nach einem der vorhergehenden Ansprüche, wobei das Brandfrüherkennungsmodul (10) eine Vielzahl von Aufnahmeelementen (19) zur Aufnahme der als separate Bauteile ausgeführten und in dem Brandfrüherkennungsmodul (10) vorgesehenen Module (11, 12, 14, 14', 16, 20) aufweist, wobei die in dem Brandfrüherkennungsmodul (10) vorgesehenen und als separate Bauteile ausgeführten Module (11, 12, 14, 14', 16, 20) als Steckmodule ausgelegt sind, die in die Aufnahmeelemente (19) eingesetzt werden können.

19. Vorrichtung nach einem der vorhergehenden Ansprüche, welche eine Vielzahl parallel arbeitende Detektionseinheiten (11, 11') und eine gemeinsamen Steuerung (12) aufweist, wobei die gemeinsame Steuerung (12) ausgelegt ist, in Abhängigkeit von jedem der mit den jeweiligen Detektionseinheiten (11, 11') ausgegebenen Nachweisergebnisse ein Brandfrüherkennungssignal auszugeben, um die Stromzufuhr des zu überwachenden Schaltschranks (100) bzw. der zu überwachenden Schaltschränke (100) abzuschalten und/oder eine Löschgaseinrichtung (20) anzusteuern, um Löschgas in den zu überwachenden Schaltschrank (100) bzw. in die zu überwachenden Schaltschränke (100) einzuleiten.

20. Vorrichtung nach Anspruch 19, wobei die gemeinsame Steuerung (12) ausgelegt ist, ein Brandfrüherkennungssignal auszugeben, wenn jedes der mit den jeweiligen Detektionseinheiten (11, 11') ausgegebenen Nachweisergebnisse auf einen Brand hinweist.

## Claims

1. Apparatus for fire detection in switchgear cabinets (100), having an intake pipe system (2), which communicates with the switchgear cabinet (100) to be monitored via at least one intake opening (2') and via which a representative air sample is taken from the switchgear cabinet (100) to be monitored, and having a early fire detection module (10) which has at least one detection unit (11, 11') for detecting at least one fire parameter in the air sample sucked in via the intake pipe system (2) and a controller (12) for outputting a early fire detection signal in response to a detection result which is output by means of the at least one detection unit (11, 11'),
**characterized in that**
the early fire detection module (10) is in the form of a slide-in rack (100') for sliding into the switchgear cabinet (100) to be monitored, and **in that**
the slide-in rack (100') has a plug connection (13) which is used to automatically connect the at least one detection unit (11, 11'), in the form of a modular component, to the intake pipe system (2) when the slide-in rack (100') has been inserted into the switchgear cabinet (100).

2. Apparatus according to Claim 1, wherein the slide-in rack (100') is a standard rack with an overall height of 1U.

3. Apparatus according to one of the preceding claims, wherein the intake pipe system (2) connects a multiplicity of switchgear cabinets (100) to be monitored, wherein the intake pipe system (2) communicates with the individual switchgear cabinets (100) to be monitored via at least one respective intake opening (2'), and wherein the intake pipe system (2) is used to take respective representative air samples from the switchgear cabinets (100) to be monitored, said air samples being supplied to the early fire detection module (10).

4. Apparatus according to one of the preceding claims, wherein the early fire detection module (10) also has a fan module (14), which can be actuated by means of the controller (12) and is in the form of a modular component, for sucking in the air samples from the switchgear cabinet (100) to be monitored or from the switchgear cabinets (100) to be monitored via the intake pipe system (2).

5. Apparatus according to Claim 4, wherein the early fire detection module (10) also has an outlet module (14'), which can be actuated by means of the controller (12) and is in the form of a separate component, for blowing out the air samples sucked into the intake pipe system (2), wherein the outlet module (14') is activated by the controller (12) when the at least one detection unit (11, 11') detects at least one fire parameter in the sucked-in air samples, and wherein the early fire detection module (10) also has an indicator element (15) which identifies the location of the fire in one of the switchgear cabinets (100) to be monitored and/or uses a communication device to transmit information regarding the origin and/or the presence of a fire in one or more of the switchgear cabinets (100) to be monitored and regarding the explicit localization of the fire in the one or more switchgear cabinets (100) to be monitored to a station which is remote from the apparatus.

6. Apparatus according to Claim 5, wherein the controller (12) is designed for time-coordinated control of the fan module (14) and of the outlet module (14') in accordance with a signal which is output by the at least one detection unit (11, 11').

7. Apparatus according to Claim 5 or 6, wherein the fan module (14) and the outlet module (14') together are in the form of a blower which changes its air conveyance direction in response to a control signal from the controller (12).

8. Apparatus according to Claim 7, wherein the fan module (14) in the form of a blower is a fan with reversal of its direction of rotation.

9. Apparatus according to Claim 7, wherein the fan module (14) in the form of a blower is a fan with ventilation flaps.

10. Apparatus according to one of the preceding claims, wherein the early fire detection module (10) also has an air stream monitoring module (16), which can be actuated by means of the controller (12) and is in the form of a modular component, for monitoring the air flow of the air samples sucked in via the intake pipe system (2).

11. Apparatus according to one of the preceding claims, wherein the early fire detection module (10) is designed to output a early fire detection signal via the controller (12) in response to a detection result which is output by means of the at least one detection unit (11, 11'), said early fire detection signal being used to switch off the supply of power to the switchgear cabinet (100) to be monitored or to the switchgear cabinets (100) to be monitored.

12. Apparatus according to one of the preceding claims, wherein the apparatus also has an extinguishing gas device (20) which can be actuated by means of the controller (12) and which, following detection of a fire parameter, introduces extinguishing gas into the switchgear cabinet (100) to be monitored or into the switchgear cabinets (100) to be monitored, the extinguishing gas device (20) being integrated in the early fire detection module (10) as a modular component or being in the form of a separate slide-in rack.

13. Apparatus according to Claim 12, wherein the extinguishing gas device (20) is arranged in the base of the switchgear cabinet (100) to be monitored or in at least one base of the switchgear cabinets (100) to be monitored, preferably in the form of extinguishing agent bottles.

14. Apparatus according to Claim 12 or 13, wherein the extinguishing gas device (20) has an extinguishing gas generator which, in the event of a fire, produces a gaseous extinguishing agent by means of a chemical reaction, particularly by means of predefined oxidation of combustible materials.

15. Apparatus according to one of Claims 12 to 14, wherein the extinguishing gas device (20) has an aerosol generator, with a chemical reaction triggered in the event of a fire being used to produce extinguishing gases, particularly nitrogen, water and potassium compounds.

16. Apparatus according to one of Claims 12 to 15, which also has a temperature-controlled ignition device for triggering the extinguishing gas device (20) when a definable temperature is exceeded.

17. Apparatus according to one of Claims 12 to 16, wherein the apparatus also has an extinguishing gas supply pipe system (22) which connects the extinguishing gas device (20) to the switchgear cabinets (100) to be monitored and which, in the event of a fire, is used to route the extinguishing gas produced by the extinguishing gas device (20) to the individual switchgear cabinets (100).

18. Apparatus according to one of the preceding claims, wherein the early fire detection module (10) has a multiplicity of holding elements (19) for holding the modules (11, 12, 14, 14', 16, 20) which are in the form of separate components and which are provided in the early fire detection module (10), the modules (11, 12, 14, 14', 16, 20) which are provided in the early fire detection module (10) and are in the form of separate components being designed as plug-in modules which can be inserted into the holding elements (19).

19. Apparatus according to one of the preceding claims, which has a multiplicity of detection units (11, 11') operating in parallel and a common controller (12), wherein the common controller (12) is designed to take each of the detection results which are output by means of the respective detection units (11, 11') as a basis for outputting a early fire detection signal in order to switch off the supply of current to the switchgear cabinet (100) to be monitored or to the switchgear cabinets (100) to be monitored and/or to actuate an extinguishing gas device (20) in order to introduce extinguishing gas into the switchgear cabinet (100) to be monitored or into the switchgear cabinets (100) to be monitored.

20. Apparatus according to Claim 19, wherein the common controller (12) is designed to output a early fire detection signal when each of the detection results which are output by means of the respective detection units (11, 11') indicates a fire.

## Revendications

1. Dispositif pour la détection d'incendie dans des armoires électriques (100), comprenant un système de tubes d'aspiration (2) qui communique via au moins une ouverture d'aspiration (2') avec l'armoire électrique (100) à surveiller et via lequel un échantillon d'air représentatif est prélevé hors de l'armoire électrique (100) à surveiller, et comprenant un module de détection précoce d'incendie (10) qui comprend au moins une unité de détection (11, 11') pour la mise en évidence d'au moins une valeur caractéristique d'incendie dans l'échantillon d'air aspiré via le système de tubes d'aspiration (2) et une commande (12) pour délivrer un signal de reconnaissance précoce d'incendie en réaction à un résultat de mise en évidence délivré par ladite au moins une unité de détection (11,11'),
**caractérisé en ce que**
le module de reconnaissance précoce d'incendie (10) est réalisé sous forme de baie encastrable (100') destinée à être encastrée dans l'armoire électrique (100) à surveiller, et
**en ce que** la baie encastrable (100') comprend un raccord enfichable (13) via lequel ladite au moins une unité de détection (11, 11') réalisée sous forme de composant modulaire est reliée automatiquement au système de tubes d'aspiration (2) quand la baie encastrable (100') est mise en place dans l'armoire électrique (100).

2. Dispositif selon la revendication 1, dans lequel la baie encastrable (100') est une baie standard d'une hauteur totale de 1 HE.

3. Dispositif selon l'une des revendications précédentes, dans lequel le système de tubes d'aspiration (2) relie une pluralité d'armoires électriques (100) à surveiller, ledit système de tubes d'aspiration (2) communiquant avec les armoires électriques (100) individuelles à surveiller via au moins une ouverture d'aspiration respective (2'), et dans lequel, à l'aide du système de tubes d'aspiration (2), des échantillons d'air représentatifs respectifs sont prélevés hors des armoires électriques (100) à surveiller, ces échantillons étant amenés au module de reconnaissance précoce d'incendie (10).

4. Dispositif selon l'une des revendications précédentes, dans lequel le module de reconnaissance précoce d'incendie (10) comprend en outre un module ventilateur (14), susceptible d'être piloté par la commande (12) et réalisé sous forme de composant modulaire, pour aspirer les échantillons d'air hors de l'armoire/des armoires électrique(s) (100) à surveiller, via le système de tubes d'aspiration (2).

5. Dispositif selon la revendication 4, dans lequel le module de reconnaissance précoce d'incendie (10) comprend en outre un module de soufflage (14'), susceptible d'être piloté par la commande (12) et réalisé sous forme de composant modulaire, pour souffler les échantillons d'air aspirés dans le système de tubes d'aspiration (2), ledit module de soufflage (14') étant activé par la commande (12) quand ladite au moins une unité de détection (11, 11') met en évidence au moins une grandeur caractéristique d'incendie dans les échantillons d'air aspirés, et le module de reconnaissance précoce d'incendie (10) comprend en outre un élément d'affichage (15) qui identifie le lieu de l'incendie dans l'une des armoires électriques (100) à surveiller et transfère, vers un emplacement éloigné du dispositif, via une unité de communication des informations concernant la naissance et/ou l'existence d'un incendie dans une ou plusieurs des armoires électriques (100) à surveiller et concernant la localisation univoque de l'incendie dans une ou plusieurs des armoires électriques (100) à surveiller.

6. Dispositif selon la revendication 5, dans lequel la commande (12) est conçue pour une commande coordonnée sur le plan temporel du module ventilateur (14) et du module de soufflage (14') en accord avec un signal délivré par ladite au moins une unité de détection (11, 11').

7. Dispositif selon la revendication 5 ou 6, dans lequel le module ventilateur (14) et le module de soufflage (14') sont réalisés conjointement sous forme d'un ventilateur qui modifie la quantité d'air refoulé en réponse à un signal de commande provenant de la commande (12).

8. Dispositif selon la revendication 7, dans lequel le module ventilateur (14) réalisé sous forme de ventilateur est un ventilateur dont le sens de rotation peut être inversé.

9. Dispositif selon la revendication 7, dans lequel le module ventilateur (14) réalisé sous forme de ventilateur est un ventilateur avec des volets de guidage d'air.

10. Dispositif selon l'une des revendications précédentes, dans lequel le module de reconnaissance précoce d'incendie (10) comprend en outre un module de surveillance d'écoulement d'air (16), susceptible d'être piloté par la commande (12) et réalisé sous forme de composant modulaire, pour la surveillance de l'écoulement des échantillons d'air aspirés via le système de tubes d'aspiration (2).

11. Dispositif selon l'une des revendications précédentes, dans lequel le module de reconnaissance précoce d'incendie (10) est conçu pour délivrer, en réponse à un résultat de mise en évidence délivré par ladite au moins une unité de détection (11, 11') via la commande (12), un signal de reconnaissance précoce d'incendie au moyen duquel l'amenée d'énergie à l'armoire/aux armoires électrique(s) (100) à surveiller est coupée.

12. Dispositif selon l'une des revendications précédentes, dans lequel le dispositif comprend en outre un système à gaz extincteur (20) susceptible d'être piloté via la commande (12), qui introduit, après reconnaissance d'une grandeur caractéristique d'incendie, un gaz extincteur dans l'armoire ou les armoires électrique(s) (100) à surveiller, ledit système à gaz extincteur (20) étant intégré sous forme de composant modulaire dans le module de reconnaissance précoce d'incendie (10) ou réalisé sous forme de baie encastrable séparée.

13. Dispositif selon la revendication 12, dans lequel le système à gaz extincteur (20) est agencé dans le socle de l'armoire électrique (100) à surveiller, ou respectivement dans au moins un socle des armoires électriques (100) à surveiller, de préférence sous la forme de bouteilles de produit extincteur.

14. Dispositif selon la revendication 12 ou 13, dans lequel le système à gaz extincteur comprend un générateur de gaz extincteur qui génère en cas d'incendie un produit extincteur sous forme gazeuse, via une réaction chimique, en particulier via une oxydation déterminée préalablement de matériaux combustibles.

15. Dispositif selon l'une des revendications 12 à 14, dans lequel le système à gaz extincteur (20) comprend un générateur d'aérosol, de sorte que l'on produit, au moyen d'une réaction chimique déclenchée en cas d'incendie, des gaz extincteurs, en particulier des composites azote/eau et potassium.

16. Dispositif selon l'une des revendications 12 à 15, qui comprend en outre un système d'amorçage piloté en température pour déclencher le système à gaz extincteur (20) lors du dépassement d'une température prédéterminée.

17. Dispositif selon l'une des revendications 12 à 16, dans lequel le dispositif comprend en outre un système de tubes d'amenée (22) pour gaz extincteur, qui relie le système à gaz extincteur (20) avec les armoires électriques (100) à surveiller et via lequel le gaz extincteur généré par le système à gaz extincteur en cas d'incendie est amené aux armoires individuelles (100).

18. Dispositif selon l'une des revendications précédentes, dans lequel le module de reconnaissance précoce d'incendie (10) comprend une pluralité d'éléments récepteurs (19) pour la réception des modules (11, 12, 14, 14', 16, 20) réalisés sous forme de composants séparés et prévus dans le module de reconnaissance précoce d'incendie (10), lesdits modules (11, 12, 14, 14', 16, 20) prévus dans le module de reconnaissance précoce d'incendie (10) et réalisés sous forme de composants séparés étant conçus sous forme de modules enfichables qui peuvent être mis en place dans les éléments récepteurs (19).

19. Dispositif selon l'une des revendications précédentes, qui comprend une pluralité d'unités de détection (11, 11') fonctionnant en parallèle et une commande commune (12), ladite commande commune (12) étant conçue pour délivrer, en fonction de chaque résultat de mise en évidence délivré par les unités de détection respectives (11, 11'), un signal de reconnaissance précoce d'incendie et pour arrêter l'alimentation électrique de l'armoire/des armoires électrique(s) (100) à surveiller et/ou pour piloter un système à gaz extincteur (20) pour introduire un gaz extincteur dans l'armoire/les armoires électrique(s) (100) à surveiller.

20. Dispositif selon la revendication 19, dans lequel la commande commune (12) est conçue pour délivrer un signal de reconnaissance précoce d'incendie quand chacun des résultats de mise en évidence délivrés par les unités de détection (11, 11') respectives indique un incendie.
